# EUROPEAN PATENT APPLICATION

(11) **EP 4 692 826 A1**
(43) Date of publication of application: **11.02.2026**
(21) Application number: 24811400.1
(22) Date of filing: 22.05.2024
(51) Int. Cl.: G01R 31/396, G01R 31/3842, G01R 31/389, G01R 31/371, G01R 31/392, G01R 19/10, G01R 22/06, G06Q 50/40, B60L 58/12, B60L 58/16

(54) **BATTERY DIAGNOSIS SYSTEM AND METHOD**

(30) Priority: 24.05.2023 KR 20230066910; 22.03.2024 KR 20240039709
(71) Applicant: LG Energy Solution, Ltd., Seoul 07335 (KR)
(72) Inventor: PARK, Ki Bum, Daejeon 34122 (KR); RO, Chang Suk, Daejeon 34122 (KR); CHAE, Min Young, Daejeon 34122 (KR)
(74) Representative: Plasseraud IP
(86) International application number: PCT/KR2024/006920
(87) International publication number: WO 2024/242461

(57) **Abstract**

According to an embodiment disclosed herein, a battery diagnosis system includes an indicator calculation unit configured to establish a database of battery data related to a battery and calculate a diagnosis criterion for diagnosing the battery and a diagnosis indicator applied to the diagnosis criterion, based on the battery data and a diagnosis apparatus configured to obtain diagnosis data related to a target battery mounted on a vehicle, calculate a value of the diagnosis indicator of the target battery based on the diagnosis data, and diagnose the target battery based on the value of the diagnosis indicator and the diagnosis criterion.

## Description

### [TECHNICAL FIELD]

### CROSS-REFERENCE TO RELATED APPLICATION

This application claims priority to and the benefit of Korean Patent Application No. 10-2024-0039709 filed in the Korean Intellectual Property Office on March 22, 2024, and Korean Patent Application No. 10-2023-0066910 filed in the Korean Intellectual Property Office on May 24, 2023, the entire contents of which are incorporated herein by reference.

### TECHNICAL FIELD

Embodiments disclosed herein relate to a battery diagnosis system and method.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc. As such batteries are rechargeable and thus available through repeated charging, periodic diagnosis is required.

### [DISCLOSURE]

### [TECHNICAL PROBLEM]

Meanwhile, a battery diagnosis process often requires an additional process such as charging/discharging for diagnosis, making it difficult to diagnose a battery in a short period of time. Therefore, a short-term diagnosis scheme for a battery is required to manage a plurality of batteries and provide user convenience.

Embodiments disclosed herein aim to provide a battery diagnosis system and method in which short-term diagnosis for a battery is possible.

Technical problems of the embodiments disclosed herein are not limited to the above-described technical problems, and other unmentioned technical problems would be clearly understood by one of ordinary skill in the art from the following description.

### [TECHNICAL SOLUTION]

According to an embodiment disclosed herein, a battery diagnosis system includes an indicator calculation unit configured to establish a database of battery data related to a battery and calculate a diagnosis criterion for diagnosing the battery and a diagnosis indicator applied to the diagnosis criterion, based on the battery data and a diagnosis apparatus configured to obtain diagnosis data related to a target battery mounted on a vehicle, calculate a value of the diagnosis indicator of the target battery based on the diagnosis data, and diagnose the target battery based on the value of the diagnosis indicator and the diagnosis criterion.

According to an embodiment disclosed herein, a battery diagnosis method includes establishing a database of battery data related to a battery and calculating a diagnosis criterion for diagnosing the battery and a diagnosis indicator applied to the diagnosis criterion, based on the battery data, obtaining diagnosis data related to a target battery mounted on a vehicle, calculating a value of the diagnosis indicator of the target battery based on the diagnosis data, and diagnosing the target battery based on the value of the diagnosis indicator and the diagnosis criterion.

### [ADVANTAGEOUS EFFECTS]

With a battery diagnosis system and method according to embodiments disclosed herein, short-term diagnosis for a battery is possible.

Moreover, various effects recognized directly or indirectly from the disclosure may be provided.

### [DESCRIPTION OF DRAWINGS]

FIG. 1 shows a structure of a battery diagnosis system according to an embodiment disclosed herein.
FIG. 2 shows an example for calculating a diagnosis indicator and a diagnosis criterion, according to an embodiment disclosed herein.
FIGS. 3A and 3B show an example for determining a swapping history of a target battery, according to an embodiment disclosed herein.
FIG. 4 shows an example for calculating a driving distance after swapping and correcting a degree of degradation, according to an embodiment disclosed herein.
FIGS. 5A and 5B show an example for calculating a diagnosis criterion for abnormality diagnosis, according to an embodiment disclosed herein.
FIG. 6 is a flowchart of a battery diagnosis method according to an embodiment disclosed herein.
FIG. 7 is a flowchart for describing an example of a process of calculating a diagnosis criterion, according to an embodiment disclosed herein.
FIG. 8 is a flowchart for describing an example of a process of correcting a degree of degradation, according to an embodiment disclosed herein.
FIG. 9 is a block diagram showing a hardware configuration of a computing system for performing a battery diagnosis method, according to an embodiment disclosed herein.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

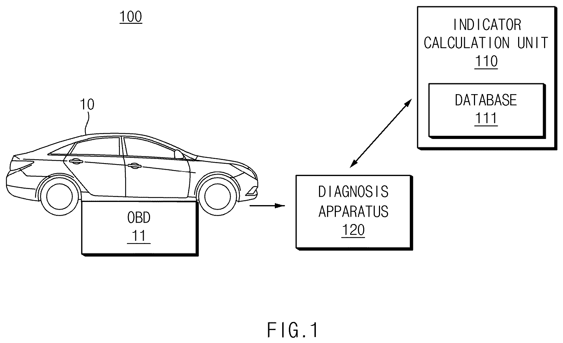

FIG. 1 shows a structure of a battery diagnosis system according to an embodiment disclosed herein.

Referring to FIG. 1, a battery diagnosis system 100 may include an indicator calculation unit 110 and a diagnosis apparatus 120.

The battery diagnosis system 100 may obtain diagnosis data related to a diagnosis target battery mounted on a vehicle 10 and diagnose the target battery by using a diagnosis criterion and a diagnosis indicator calculated from accumulative battery data stored in a database 110.

To this end, the battery diagnosis system 100 may obtain and accumulate battery data for various batteries to establish the database 111 for the battery data, and analyze a huge amount of battery data stored in the database 111 to calculate the diagnosis indicator and the diagnosis criterion for diagnosis of the battery. For example, the diagnosis indicator and the diagnosis criterion may be calculated through statistical analysis of the battery data of the database 111.

As the battery diagnosis system 100 analyzes a huge amount of data to calculate the diagnosis indicator and the diagnosis criterion, the battery diagnosis system 100 may calculate universal and generally applicable diagnosis indicator and diagnosis criterion for any target battery.

Generally, to diagnose a state of a battery such as the degree of degradation of the battery, an additional process such as performing actual charging/discharging by applying current, etc., may be required and thus a long period of time may be consumed for battery diagnosis. By contrast, the battery diagnosis system 100 may analyze a huge amount of data to calculate the diagnosis indicator and the diagnosis criterion and calculate a value of the diagnosis indicator from data obtained in a short period of time in diagnosis of a target battery, thereby performing battery diagnosis. In this way, the battery diagnosis system 100 may enable short-term diagnosis of the battery.

The indicator calculation unit 110 and the diagnosis apparatus 120 may be wiredly or wirelessly connected to each other. In an embodiment, connection between the indicator calculation unit 110 and the diagnosis apparatus 120 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection between the indicator calculation unit 110 and the diagnosis apparatus 120 may be connection using a device-to-device communication scheme (e.g., a bus, a general-purpose input and output (GPIO), a serial peripheral interface (SPI), or a mobile industry processor interface (MIPI)).

The indicator calculation unit 110 may be implemented with various computing devices such as servers, workstations, clouds, data drives, data stations, etc.

The indicator calculation unit 110 may include a communication circuit for obtaining battery data, a memory including the database 111 that stores, classifies, and manages the obtained battery data, a processor for analyzing the battery data to calculate a diagnosis indicator and a diagnosis criterion, etc.

For example, the communication circuit of the indicator calculation unit 110 may establish a wired communication channel and/or a wireless communication channel with the diagnosis apparatus 120, and transmit and receive data to and from the diagnosis apparatus 120 through the established communication channel. Likewise, the communication circuit of the indicator calculation unit 110 may establish a communication channel with various external devices (e.g., a battery management system (BMS), a vehicle BMS, a charger, a charger/discharger, etc.) capable of obtaining the battery data and obtain the battery data through the communication channel.

The indicator calculation unit 110 may establish the database 111 for the battery data related to the battery. The indicator calculation unit 110 may obtain the battery data from various components included in each battery, such as a BMS, a vehicle BMS, a charger, or a charger/discharger.

The indicator calculation unit 110 may store the obtained battery data and establish the database 111. The database 111 may be continuously updated, and for example, may obtain diagnosis data obtained in diagnosis of the target battery from the diagnosis apparatus 120 and store the obtained diagnosis data in the database 111.

The indicator calculation unit 110 may obtain various data related to the battery from the battery data. For example, the battery data related to the battery may include data related to the state of the battery, data related to the state of an electronic device having mounted thereon the battery. For example, the indicator calculation unit 110 may include, as data related to the state of the battery, a voltage, a current, a resistance, a state of charge (SOC), a state of health (SOH), a temperature, etc., of the battery.

The indicator calculation unit 110 may calculate the diagnosis indicator and the diagnosis criterion for diagnosis of the battery, based on the battery data. The indicator calculation unit 120 may collect the data of the battery and analyze the same to calculate statistical diagnosis indicator and diagnosis criterion. For example, the indicator calculation unit 120 may form big data for the battery data to calculate the diagnosis indicator and the diagnosis criterion based on the big data.

The indicator calculation unit 110 may calculate indices available for battery diagnosis of the diagnosis apparatus 120 in a process of analyzing the battery data and calculating the diagnosis criterion. The diagnosis criterion may include, for example, a degradation degree criterion for diagnosing the degree of degradation of the battery, an abnormality criterion for diagnosing whether the battery is abnormal, and so forth.

In an embodiment, the indicator calculation unit 110 may analyze a correlation between various factors related to the battery, included in the battery data, to calculate the diagnosis indicator and the diagnosis criterion. For example, the indicator calculation unit 110 may analyze a correlation between the degree of degradation and factors (e.g., an accumulative driving distance, etc.) expected to be related or known as being related to the degree of degradation to calculate the degradation degree criterion.

According to an embodiment, the indicator calculation unit 110 may analyze a correlation between the accumulative driving distance and the degree of degradation and a correlation between a charging habit and the degree of degradation to calculate a degradation degree criterion and a diagnosis indicator applied thereto. In an embodiment, the charging habit may include a fast charging rate of the battery.

For example, the indicator calculation unit 110 may statistically analyze the correlation between the accumulative driving distance and the degree of degradation to derive a correlation graph indicating the degree of degradation with respect to the accumulative driving distance. When the indicator calculation unit 110 derives the correlation between the accumulative driving distance and the degree of degradation, the indicator calculation unit 110 may calculate the accumulative driving distance as the diagnosis indicator and calculate the correlation graph as the diagnosis criterion for diagnosis.

Likewise, the indicator calculation unit 110 may analyze the correlation between the charging habit and the degree of degradation to reflect the degree of degradation with respect to the accumulative driving distance to the correlation graph.

In an embodiment, the indicator calculation unit 110 may calculate the diagnosis criterion such that the accumulative driving distance the degree of degradation basically has a negative correlation, but may set the diagnosis criterion such that even for the same accumulative driving distance, the degree of degradation differs with the charging habit. For example, the degradation degree criterion may be calculated such that the degree of degradation decreases as the accumulative driving distance increases and even for the same accumulative driving distance, the degree of degradation decreases as the fast charging rate increases.

According to an embodiment, the indicator calculation unit 110 may calculate a diagnosis indicator and a diagnosis criterion based on a type of a vehicle. For example, the indicator calculation unit 110 may classify the battery data according to the obtained type of the vehicle and analyze the classified battery data to calculate the diagnosis indicator and the diagnosis criterion according to the type of the vehicle.

Even for the same indicator, a correlation with a diagnosis purpose (e.g., the degree of degradation) may vary with the type of the vehicle having mounted thereon the battery, etc., such that the indicator calculation unit 110 may calculate the diagnosis indicator and the diagnosis criterion based on the type of the vehicle from which the battery data is obtained.

According to an embodiment, the indicator calculation unit 110 may estimate a diagnosis criterion of another vehicle based on a charging habit and a stored/left voltage for each vehicle. Herein, the charging habit may be calculated based on a ratio of an accumulative power to an accumulative current, as described above, and the stored/left voltage may mean a voltage applied in a rest period of the battery and may be calculated based on the ratio of the accumulative power to the accumulative current.

As described above, when the accumulative current, the accumulative power, and the correlation between the fast charging rate and the degree of degradation are derived in calculation of the degradation degree criterion, the indicator calculation unit 110 may compare data for each vehicle to derive a new indicator available for degradation degree diagnosis. For example, the indicator calculation unit 110 may determine whether the stored/left voltage is available as the diagnosis indicator for degradation degree diagnosis.

As such, the indicator calculation unit 110 may analyze, according to the fast charging rate and the stored/left voltage of the vehicle, a correlation between each parameter and the degree of degradation of the battery, and calculate a diagnosis indicator and a diagnosis criterion for degradation degree diagnosis for a vehicle or a battery having no history for the battery data by using a derived correlation tendency.

According to an embodiment, the indicator calculation unit 110 may calculate the diagnosis indicator and the diagnosis criterion for abnormality diagnosis of the battery, based on the battery data.

According to an embodiment, the diagnosis criterion may include a criterion for at least any one of a voltage deviation, a temperature deviation, and an insulation resistance. However, the present disclosure is not limited thereto.

According to an embodiment, the indicator calculation unit 110 may analyze the battery data to derive a charging rate and an open circuit as diagnosis indicators for voltage deviation diagnosis. The indicator calculation unit 110 may derive a relationship between a charging rate and an open voltage, included in the battery data, to calculate a diagnosis criterion for abnormality diagnosis.

According to an embodiment, the indicator calculation unit 110 may calculate a graph indicating the relationship between the charging rate and the open voltage. The indicator calculation unit 110 may analyze data regarding the charging rate and data regarding the open voltage to calculate a graph indicating a correlation therebetween.

Thereafter, the indicator calculation unit 110 may shift the graph at preset intervals. Herein, when the graph is shifted at preset intervals, it may mean that the graph is moved along at least one axis. For example, the indicator calculation unit 110 may move the graph along an axis indicating a charging rate to analyze the voltage deviation.

According to an embodiment, the indicator calculation unit 110 may calculate a diagnosis criterion for the voltage deviation with respect to the charging rate, based on a difference between the graph before shifted and the graph after shifted. As the indicator calculation unit 110 shifts the graph for the charging rate and the open circuit and calculate the difference between the graph before shifted and the graph after shifted, the indicator calculation unit 110 may calculate the voltage deviation with respect to the charging rate.

According to an embodiment, the indicator calculation unit 110 may set the diagnosis criterion by using voltage deviation values, calculated in this way, with respect to the charging rate, as threshold values. For example, when a voltage deviation for a charging rate a is calculated as b, b may be a threshold value for diagnosing voltage deviation abnormality.

An example of the above-described diagnosis criterion calculation may be an example of calculating a diagnosis criterion for diagnosing voltage deviation abnormality, and a diagnosis criterion for diagnosing temperature deviation abnormality or insulation resistance abnormality may also be calculated in a similar manner.

For example, when calculating the diagnosis criterion for diagnosing temperature deviation abnormality, the indicator calculation unit 110 may analyze a correlation between at least two factors having a relationship with a temperature deviation and derive a graph indicating the correlation. Thereafter, the diagnosis criterion for diagnosing the temperature deviation may be calculated using the calculated graph.

The diagnosis apparatus 120 may be implemented with various computing devices such as servers, workstations, clouds, data drives, data stations, etc.

The diagnosis apparatus 120 may include components such as a communication circuit for obtaining diagnosis data, a memory that stores the obtained diagnosis data, a processor that analyzes the diagnosis data to calculate a diagnosis result, etc. The diagnosis apparatus 120 may further include other components, or at least one component thereof may be removed.

The diagnosis apparatus 120 may obtain diagnosis data of a battery targeted for diagnosis to diagnose a target battery.

The diagnosis apparatus 120 may be implemented by being physically separated from the indicator calculation unit 110. For example, the diagnosis apparatus 120 and the indicator calculation unit 110 may be implemented as separate servers that are physically separated from each other and connected to each other over a network.

In some cases, the diagnosis apparatus 120 may be implemented as the same physical component as the indicator calculation unit 110. For example, the diagnosis apparatus 120 and the indicator calculation unit 110 may be components of the same server.

The diagnosis apparatus 120 may obtain diagnosis data of the target battery mounted on the vehicle. The target battery may be a battery targeted for diagnosis. The diagnosis apparatus 120 may obtain the diagnosis data without a separate additional process for diagnosis, such as removing the target battery from the vehicle or separately charging/discharging the target battery. For example, the diagnosis apparatus 120 may obtain diagnosis data for a short period of time in a state where the target battery is in operation.

According to an embodiment, the diagnosis apparatus 120 may obtain the diagnosis data from on-board diagnostic (OBD) equipment 11 included in the vehicle 10. The OBD equipment 11 may obtain vehicle data or battery data as the diagnosis data from a component included in the vehicle 10 and related to the vehicle 10, or a component such as a BMS, etc., of the target battery. For example, the diagnosis data may include an accumulative driving distance of the vehicle, an accumulative current, an accumulative power, etc., of the target battery. For example, the accumulative current and the accumulative power of the target battery may be recorded in the BMS of the target battery. The OBD equipment 11 may obtain the battery-related data recorded in a battery storage system of the target battery as the diagnosis data.

The OBD equipment 11 may transmit the diagnosis data to the diagnosis apparatus 120. For example, a network may be formed for communication between the OBD equipment 11 and the diagnosis apparatus 120, and the diagnosis apparatus 120 may receive the diagnosis data from the OBD equipment 11.

In an embodiment, the OBD equipment 11 may obtain, as the diagnosis data, data related to the vehicle and/or the battery in a short period of time. For example, the OBD equipment 11 may obtain the diagnosis data in a short period of time, 1 minute or less.

In this case, as the diagnosis data may be data obtained in a short period of time, data that may be obtained through a separate charging/discharging process or a separate process may not be included. That is, the diagnosis data may include information that is simply obtained from data stored in the BMS or is obtainable through short-term monitoring. For example, the diagnosis data may not include SOH information of the target battery.

According to an embodiment, the diagnosis apparatus 120 may calculate a value of a diagnosis indicator of the target battery based on the diagnosis data. The diagnosis apparatus 120 may receive a diagnosis indicator and a diagnosis criterion from the indicator calculation unit 110 and calculate a value of the diagnosis indicator from the diagnosis data.

According to an embodiment, the diagnosis apparatus 120 may diagnose the degree of degradation of the target battery by using a use feature of the battery and an accumulative driving distance of the vehicle as diagnosis indicators.

According to an embodiment, the diagnosis apparatus 120 may calculate the use feature for the target battery based on the diagnosis data. Herein, the use feature may mean features related to accumulative use of the target battery, and may include, for example, a charging habit, a use pattern, a swapping history, etc.

According to an embodiment, the diagnosis apparatus 120 may calculate the use feature based on the accumulative power and the accumulative current of the target battery, included in the diagnosis data. The accumulative power may mean a charging/discharging power accumulated in a charging/discharging process of the target battery, and the accumulative current may mean a charging/discharging current accumulated in charging/discharging of the target battery.

According to an embodiment, the use feature may include a charging habit for the target battery. As the degradation of the battery may be accelerated depending on the charging habit for the battery, the diagnosis apparatus 120 may calculate the charging habit as the use feature of the target battery.

According to an embodiment, the charging habit for the target battery may include a fast charging rate, and the diagnosis apparatus 120 may calculate the fast charging rate based on a ratio of an accumulative power to an accumulative current (= accumulative power/accumulative current). A high ratio of the accumulative power to the accumulative current may mean a high average operating voltage of the battery, which may mean a high fast charging rate.

When the average operating voltage of the target battery is high, the charging current of the target battery may be high or an SOC use region of the target battery may be high, such that the degradation of the target battery may be accelerated. Thus, the diagnosis apparatus 120 may calculate the fast charging rate from the ratio of the accumulative power to the accumulative current.

In another embodiment, the accumulative power may include an accumulative charging power and an accumulative discharging power, and the accumulative current may include an accumulative charging current and an accumulative discharging current. In this case, the diagnosis apparatus 120 may calculate the fast charging rate based on a difference between a ratio of an accumulative charging power to an accumulative charging current (= accumulative charging power/accumulative charging current) and a ratio of an accumulative discharging power to an accumulative discharging current (= accumulative discharging power/accumulative discharging current). This may originate from a fact that statistically, the fast charging rate is large as a corresponding value of the battery data is large.

According to an embodiment, the diagnosis apparatus 120 may determine whether the target battery has ever been swapped and calculate a driving distance after swapping to correct the degree of degradation of the target battery, thereby enabling more accurate diagnosis.

According to an embodiment, the diagnosis apparatus 120 may determine whether the target battery has ever been swapped, based on at least one of the accumulative current and the accumulative driving distance. That is, the diagnosis apparatus 120 may calculate, as a use feature of the battery, whether the target battery has ever been swapped.

When the target battery has a history of being swapped, a relationship between the accumulative driving distance of the target battery and the accumulative current and/or the accumulative power may change and degradation degree diagnosis may be inaccurate, such that the diagnosis apparatus 120 may determine whether the target battery has ever been swapped.

According to an embodiment, the diagnosis apparatus 120 may determine whether the target battery has ever been swapped, based on a change of an accumulative current over time. As the accumulative current of the battery proportionally increases over an operating time, the diagnosis apparatus 120 may determine from the change of the accumulative current over time whether the target battery has ever been swapped. For example, the accumulative current over time may be stored in the BMS of the target battery, and the diagnosis apparatus 120 may obtain, as diagnosis data, data stored in the BMS to determine whether the target battery has ever been swapped.

In an embodiment, the diagnosis apparatus 120 may determine that the target battery has a history of being swapped, when the accumulative current sharply decreases at a specific point in time.

As the accumulative current increases over time unless the battery is swapped, the diagnosis apparatus 120 may determine that the corresponding battery has a history of being swapped when the accumulative current decreases at a specific point in time.

According to an embodiment, the diagnosis apparatus 120 may determine whether the target battery has ever been swapped, based on a ratio of the accumulative driving distance to the accumulative current (=accumulative driving distance/accumulative current). For example, the diagnosis apparatus 120 may compare the ratio of the accumulative driving distance to the accumulative current with a specific value or analyze a graph derived from the accumulative driving distance and the accumulative current to determine whether the target battery has ever been swapped.

In an embodiment, when the ratio of the accumulative driving distance to the accumulative current exceeds a threshold value or the graph indicating the relationship between the accumulative driving distance and the accumulative current, when extended, does not converge to the origin, the diagnosis apparatus 120 may determine that the target battery has a history of being swapped.

When the ratio of the accumulative driving distance to the accumulative current exceeds the threshold value, it may mean that the accumulative driving distance is much greater than the accumulative current, such that it may be determined that the target battery has a history of being swapped.

The diagnosis apparatus 120 may obtain, as diagnosis data, data regarding the accumulative current and the accumulative driving distance. For example, time-series data for the accumulative current and the accumulative driving distance may be stored in the BMS of the target battery, and the diagnosis apparatus 120 may obtain the time-series data. The diagnosis apparatus 120 may analyze a distribution for the accumulative current and the accumulative driving distance and derive the graph indicating the relationship between the accumulative driving distance and the accumulative current.

Without a history of swapping of the target battery, when the battery is initially mounted on the vehicle, both the accumulative current and the accumulative driving distance are 0, such that the graph indicating the relationship between the accumulative driving distance and the accumulative current, when extended, may converge to the origin. Thus, the diagnosis apparatus 120 may determine that the target battery has a history of being swapped, when the extended graph does not converge to the origin.

According to an embodiment, the diagnosis apparatus 120 may calculate a driving distance after swapping of the target battery when determining that the target battery has a history of being swapped. For example, the diagnosis apparatus 120 may obtain the accumulative current and the accumulative driving distance of the target battery from the diagnosis data and express them on a two-dimensional (2D) plane having them as axes. In this case, when it is determined that the target battery has a history of being swapped, the driving distance after swapping may be calculated as a difference between an y-axis intercept and a y coordinate when a slope is extended.

According to an embodiment, the diagnosis apparatus 120 may correct the degree of degradation based on the driving distance after swapping. This may be understood as comparing the driving distance and the use feature (more specifically, the fast charging rate) after swapping with the diagnosis criterion to recalculate the degree of degradation.

According to an embodiment, the diagnosis apparatus 120 may diagnose the target battery based on the diagnosis indicator and the diagnosis criterion. The diagnosis apparatus 120 may calculate the diagnosis indicate from the diagnosis data and may perform diagnosis on the target battery in a short period of time by using the diagnosis criterion.

According to an embodiment, the diagnosis apparatus 120 may diagnose the degree of degradation of the target battery by comparing a use feature and an accumulative driving distance of the vehicle with the diagnosis criterion. In this case, the accumulative driving distance of the vehicle may be included in the diagnosis data. For example, the accumulative driving distance of the vehicle may be recorded in the BMS, and the diagnosis apparatus 120 may obtain the accumulative driving distance of the vehicle.

For example, as described above, the indicator calculation unit 110 may analyze the relationship between the accumulative driving distance and the use feature and the degree of degradation to set the diagnosis criterion, and the diagnosis apparatus 120 may diagnose the degree of degradation of the target battery by using the set diagnosis criterion.

For example, the indicator calculation unit 110 may calculate the diagnosis criterion in the form of a function for diagnosis indicators, and the diagnosis apparatus 120 may input the diagnosis indicators to the diagnosis function to output the degree of degradation.

According to an embodiment, the diagnosis apparatus 120 may perform abnormality diagnosis of the battery by using an abnormality diagnosis criterion. For example, the diagnosis apparatus 120 may diagnose temperature deviation abnormality of the target battery by using the criterion for the temperature deviation.

For example, a threshold value for each abnormality diagnosis may be set as the diagnosis criterion for each abnormality diagnosis, and the diagnosis apparatus 120 may compare the diagnosis indicator calculated from the diagnosis data with the threshold value and perform abnormality diagnosis of the target battery.

According to an embodiment, the diagnosis apparatus 120 may transmit a diagnosis result for the target battery to an external device. For example, the diagnosis apparatus 120 may transmit the diagnosis result to the OBD equipment 11 that obtains the diagnosis data. In this case, the OBD equipment 11 may include a component capable of displaying the diagnosis result. For example, the OBD equipment 11 may include an interface that displays the diagnosis result.

In another example, the diagnosis apparatus 120 may transmit the diagnosis result to a device that manages a place where the vehicle having mounted thereon the target battery is inspected, a user terminal of a user that manages the vehicle having mounted thereon the target battery, etc.

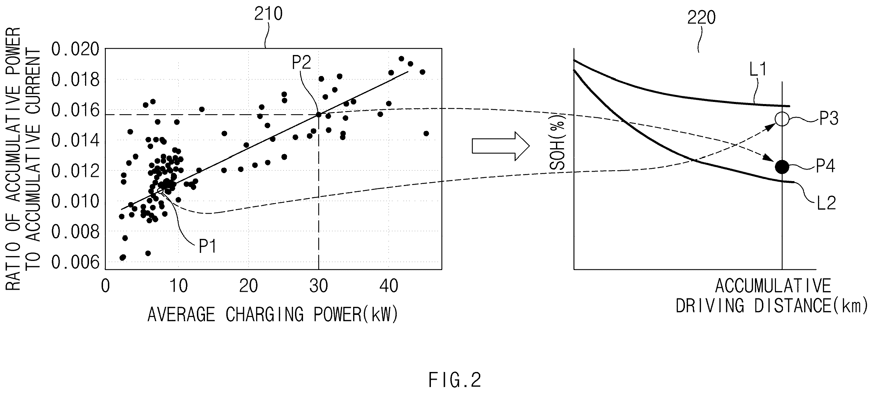

FIG. 2 shows an example for calculating a diagnosis indicator and a diagnosis criterion, according to an embodiment disclosed herein.

Referring to FIG. 2, a graph 210 indicating a correlation between the fast charging rate and the ratio of the accumulative power to the accumulative current and a graph 220 indicating a diagnosis criterion calculated based on the correlation are shown as examples.

First, referring to 210 of FIG. 2, a relationship between a ratio of an accumulative power to an accumulative current and an average charging power may be statistically analyzed based on battery data stored in the database 111. Herein, a high average charging power may mean that charging of the battery is performed fast, that is, the fast charging rate of the battery is high. Thus, it may be seen that there is a correlation of a charging habit of a higher fast charging rate for a higher ratio of an accumulative power to an accumulative current. In this case, the degree of degradation of the battery may decrease as the fast charging rate increases, such that the indicator calculation unit 110 may calculate the fast charging rate (or the accumulative power and the accumulative current) as the diagnosis indicator.

The indicator calculation unit 110 may calculate the diagnosis criterion for degradation degree diagnosis based on the correlation between the ratio of the accumulative power to the accumulative current and the charging habit. For example, the indicator calculation unit 110 may statistically analyze the correlation between the accumulative driving distance and the degree of degradation from the battery data stored in the database to calculate a reference graph indicating the degree of degradation of the battery with respect to the accumulative driving distance. Thereafter, the indicator calculation unit 110 may set the diagnosis criterion based on the correlation between the ratio of the accumulative power to the accumulative current and the fast charging rate such that the reference graph changes with the fast charging rate.

For example, as indicated by 220 of FIG. 2, the indicator calculation unit 110 may analyze the degree of degradation with respect to the accumulative driving distance to derive a minimum degradation graph L1 and a maximum degradation graph L2 as diagnosis reference graphs. The indicator calculation unit 110 may cause the degree of degradation to change between L1 and L2 according to the fast charging rate.

For example, the degree of degradation corresponding to a point P1 at which the fast charging rate is low may be P3 that is close to the minimum degradation graph L1, and the degree of degradation corresponding to a point P2 at which the fast charging rate is high may be P4 that is close to the maximum degradation graph L2.

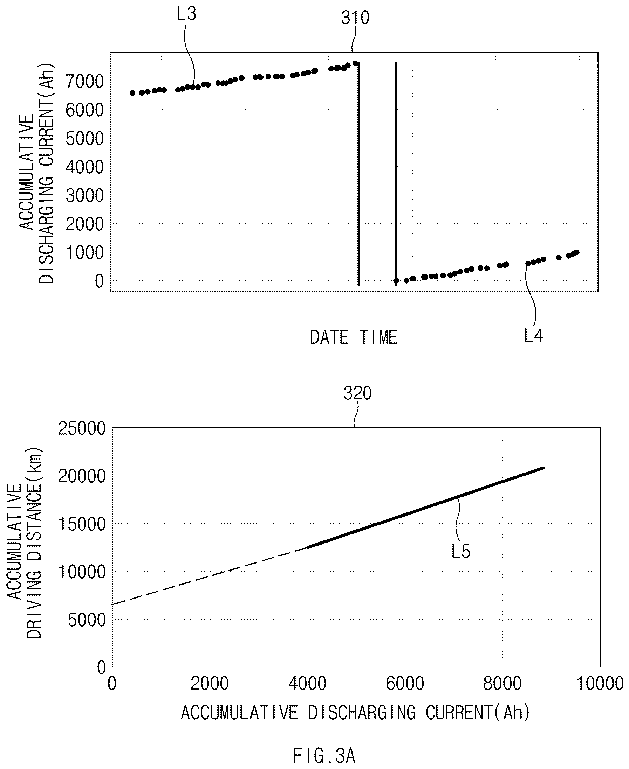

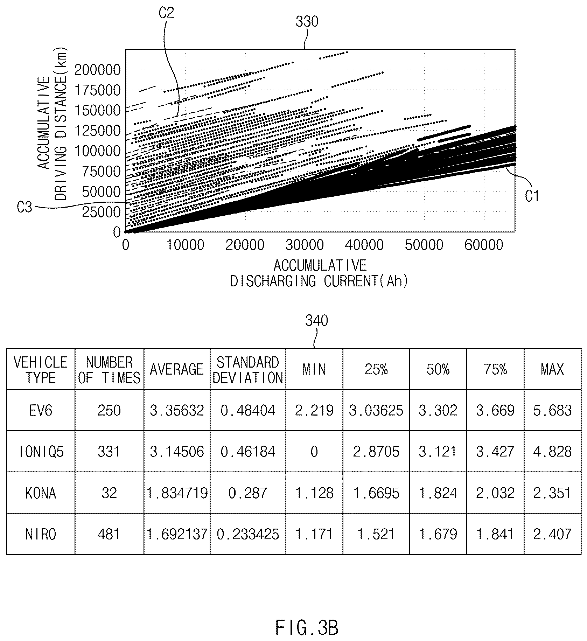

FIGS. 3A and 3B show an example for determining a swapping history of a target battery, according to an embodiment disclosed herein.

Referring to FIG. 3A, graphs 310 and 320 showing an example of a change of battery data in case of swapping of a battery are shown.

Referring to 310 of FIG. 3, a graph of an accumulative discharging current over time is shown as an example. The accumulative discharging current over time may be obtained from, for example, a BMS of the battery. In 310 of FIG. 3, L3 may indicate an accumulative discharging current of the battery before swapped and L4 may indicate an accumulative discharging current of the battery after swapped.

Comparing L3 with L4, it may be seen that in a process from L3 to L4, a rest period occurs during swapping of the battery and the accumulative discharging current sharply decreases. Thus, the diagnosis apparatus 120 may determine whether the target battery has ever been swapped, by checking a point in time at which the accumulative current of the battery sharply decreases.

320 of FIG. 3A indicates a graph indicating a relationship between an accumulative discharging current and an accumulative driving distance. As indicated by 320 of FIG. 3, the diagnosis apparatus 120 may obtain time-series data of the accumulative discharging current and the driving distance over time and express the relationship between the accumulative discharging current and the accumulative driving distance as a 2D graph. In this case, the diagnosis apparatus 120 may calculate a slope of a graph L5 indicating a relationship between the accumulative driving distance and the accumulative discharging current and determine whether the graph converges to the origin when the graph is extended with the calculated slope. The diagnosis apparatus 120 may determine that the target battery has a history of being swapped, when the extended graph does not converge to the origin.

330 of FIG. 3B indicates graphs indicating a relationship between the accumulative discharging current and the accumulative driving distance of battery data stored in the database. Referring to 330 of FIG. 3B, the diagnosis apparatus 120 may determine that the target battery has a history of being swapped when a slope of the accumulative discharging current and the accumulative driving distance exceeds a threshold value.

For example, in 330 of FIG. 3B, a graph C1 may indicate a case where the battery has not ever been swapped, a graph C2 may indicate a case where the accumulative discharging current sharply decreases, and a graph C3 may indicate a case where the extended graph does not converge to the origin.

The diagnosis apparatus 120 may determine that the target battery has a history of being swapped, when the ratio of the accumulative driving distance to the accumulative discharging current exceeds a threshold value. 340 of FIG. 3B indicates an example of data analysis for setting the threshold value.

Referring to 340 of FIG. 3B, by analyzing a fuel efficiency of repeatedly obtained battery data, a threshold value for determining a swapping history of the battery may be set. In 340, columns may respectively mean a vehicle type from which data is obtained, the number of times the data is obtained, an average of fuel efficiencies, a standard deviation, a minimum value of fuel efficiencies, a bottom 25 % value of a fuel efficiency distribution, a bottom 50 % value of the fuel efficiency distribution, a bottom 75 % value of the fuel efficiency distribution, and a maximum value of fuel efficiencies. In this case, it may be seen that the average of the fuel efficiencies and the bottom 75 % value of the fuel efficiency distribution have the most similar values over the whole vehicle types, such that the diagnosis apparatus 120 may set the threshold value, to, for example, 75 % (0.75).

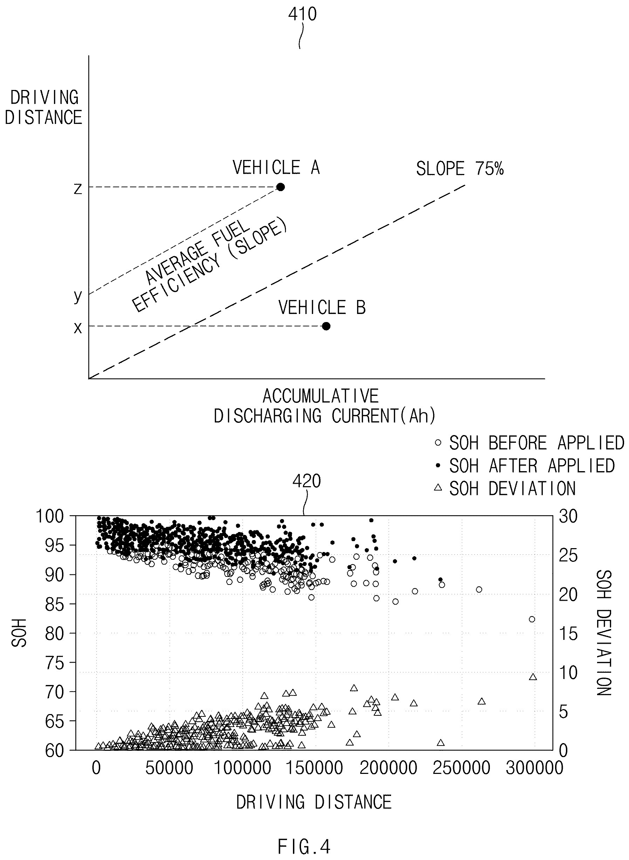

FIG. 4 shows an example for calculating a driving distance after swapping and correcting a degree of degradation, according to an embodiment disclosed herein.

Referring to FIG. 4, when the diagnosis apparatus 120 determines that the target battery has a history of being swapped, the diagnosis apparatus 120 may calculate a driving distance after swapping and correct a degree of degradation.

In 410 of FIG. 4, a vehicle A means a vehicle determined to have a battery swapped, and a vehicle B means a vehicle determined to have a battery not swapped. For the vehicle B, the battery has not been swapped and thus obtained accumulative driving distance data X may be used.

For the vehicle A, the battery has been swapped and thus the driving distance after swapping may be calculated. In this case, an obtained accumulative driving distance Z may be connected using an average fuel efficiency (slope) to obtain an intercept value y. Herein, it should be noted that the average fuel efficiency may be obtained from time-series data of the accumulative driving distance and the accumulative discharging current of the battery mounted on the vehicle A and may be different from a slope of 75 % for distinguishing the vehicle A from the vehicle B. The diagnosis apparatus 120 may calculate the driving distance after swapping as z - y for the vehicle A.

In 420 of FIG. 4, a distribution of a degree of degradation with respect to an accumulative driving distance is shown. White circular dots may indicate SOH diagnosis results when it is not determined whether a battery has ever been swapped, black circular dots may indicate SOH diagnosis results when it is determined whether a battery has ever been swapped, and triangular dots may indicate SOH deviations before and after it is determined whether a battery has ever been swapped. As a result, as in 420 of FIG. 4, it may be seen that a diagnosed degree of degradation is improved.

Thus, the battery diagnosis system 100 may determine whether a battery has ever been swapped to improve the accuracy of actual SOH diagnosis. Moreover, it is possible to solve a loss or user complaints caused by faster-than-expected swapping due to a battery's SOH being diagnosed as lower than an actual degradation degree when a history of swapping is not determined.

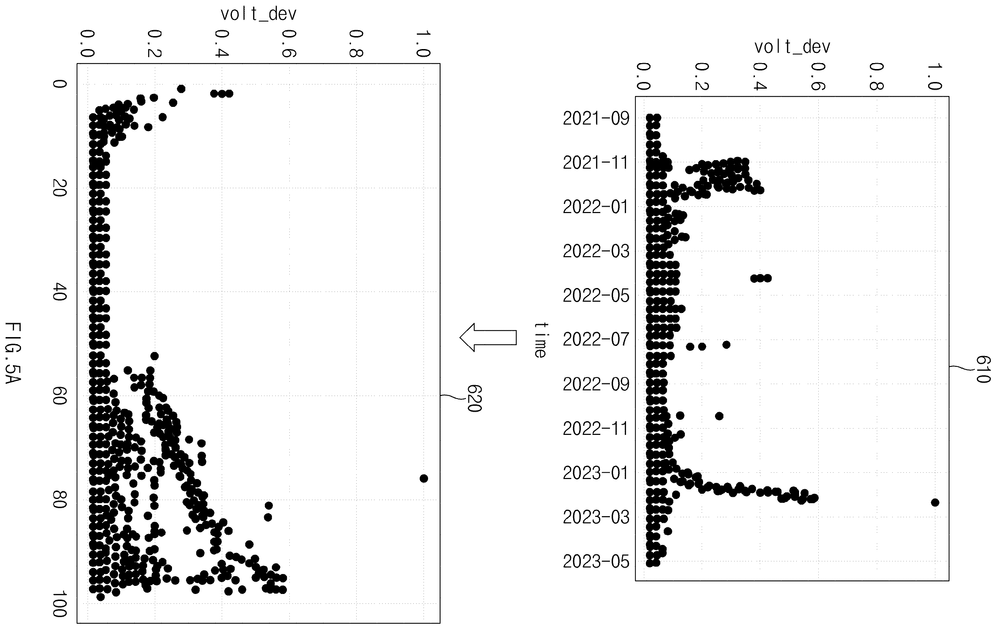

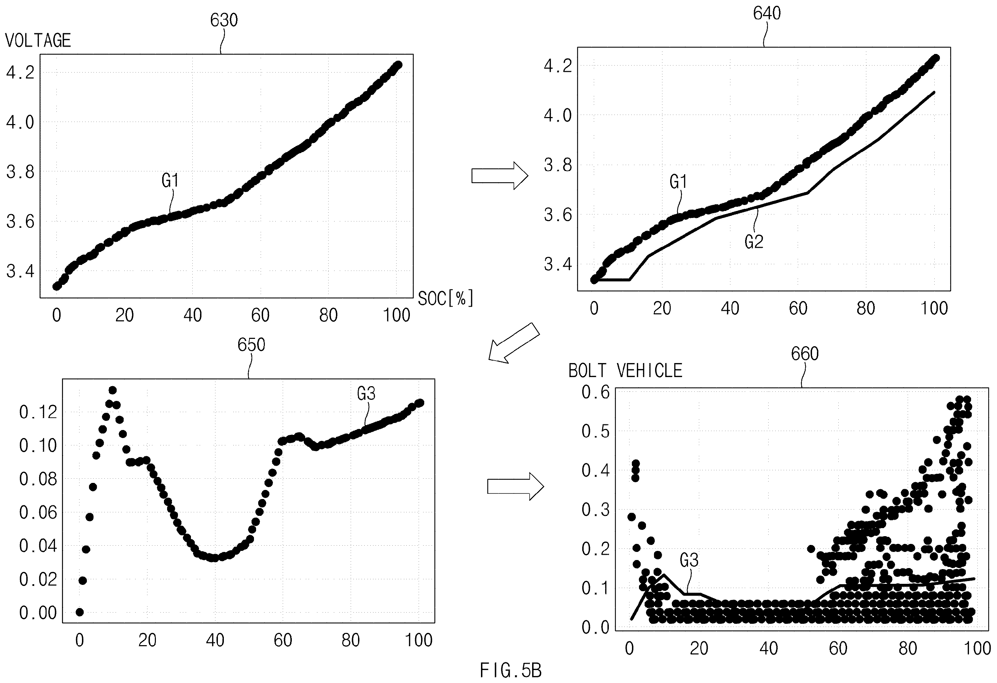

FIGS. 5A and 5B show an example for calculating a diagnosis criterion for abnormality diagnosis, according to an embodiment disclosed herein.

An example for calculating a voltage deviation diagnosis criterion is shown in FIG. 5A, and the indicator calculation unit 110 may obtain accumulative data for a voltage deviation and an SOC. The indicator calculation unit 110 may derive a voltage deviation distribution 610 over time and a voltage deviation distribution 620 with respect to an SOC from data for the voltage deviation and the SOC. The indicator calculation unit 110 may obtain a voltage deviation distribution 620 with respect to an SOC by matching voltage deviation data over time to the SOC at each point in time.

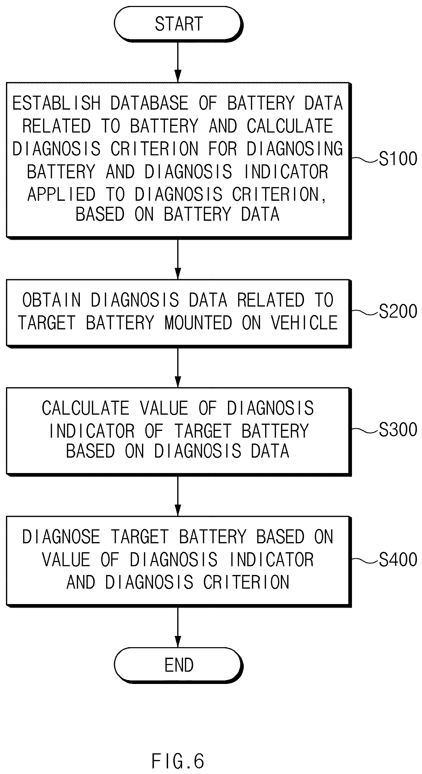

Referring to FIG. 5B, the indicator calculation unit 110 may derive, from battery data, an open voltage distribution 630 with respect to an SOC and a graph G1 indicating a relationship between the SOC and an open voltage. The indicator calculation unit 110 may obtain a shifted graph G2 obtained by shifting the graph G1. For example, as in 640 of FIG. 6, a graph may be shifted by an SOC of 10 %.

Thereafter, the indicator calculation unit 110 may obtain a graph G3 indicating a difference between the graph G1 and the shifted graph G2. The graph G3 may be a graph of a voltage deviation with respect to an SOC, and the indicator calculation unit 110 may calculate the graph G3 as a diagnosis criterion for determining voltage deviation abnormality with respect to an SOC.

For example, as in 660 of FIG. 5B, data above the graph G3 calculated as the diagnosis criterion may be determined to correspond to the voltage deviation abnormality. In this case, a distribution of a voltage deviation with respect to an SOC used in 660 may be the same as a distribution shown in 620.

FIG. 6 is a flowchart of a battery diagnosis method according to an embodiment disclosed herein.

Referring to FIG. 6, a battery diagnosis method may include operation S100 of establishing a database of battery data related to a battery and calculating a diagnosis criterion for diagnosing the battery, based on the battery data, operation S200 of obtaining diagnosis data of a target battery mounted on a vehicle, operation S300 of calculating a use feature for the target battery from the diagnosis data, and operation S400 of diagnosing the target battery based on the use feature, the diagnosis data, and the diagnosis criterion.

In operation S100, the indicator calculation unit 110 may establish the database for the battery data. The indicator calculation unit 110 may calculate the diagnosis indicator and the diagnosis criterion for diagnosis of the battery. For example, the diagnosis criterion may include, for example, a criterion for diagnosing the degree of degradation of the battery, a criterion for diagnosing whether the battery is abnormal, and so forth.

In operation S200, the diagnosis apparatus 120 may obtain the diagnosis data of the target battery. In an embodiment, the diagnosis apparatus 120 may obtain the diagnosis data from OBD equipment included in the vehicle, in which the diagnosis data may be data obtained for a short period of time.

In operation S300, the diagnosis apparatus 120 may calculate a value of a diagnosis indicator of the target battery based on the diagnosis data. For example, the diagnosis apparatus 120 may receive a diagnosis indicator from the indicator calculation unit 110 and calculate a value of the diagnosis indicator from the diagnosis data.

In operation S400, the diagnosis apparatus 120 may diagnose the target battery based on the value of the diagnosis indicator and the diagnosis criterion. The diagnosis apparatus 120 may diagnose the target battery merely with the diagnosis data obtained in a short period of time by using a diagnosis criterion previously calculated from the indicator calculation unit 110.

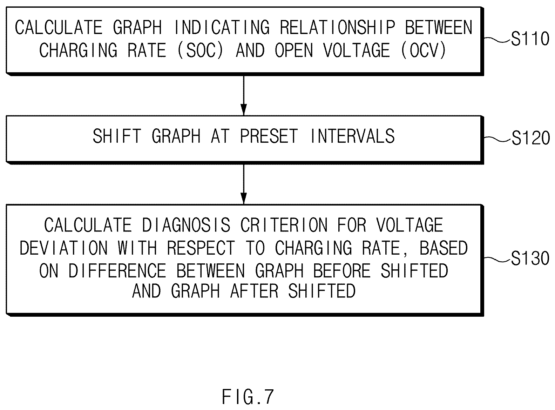

FIG. 7 is a flowchart for describing an example of a process of calculating a diagnosis criterion, according to an embodiment disclosed herein.

Referring to FIG. 7, the indicator calculation unit 110 may calculate a diagnosis criterion by analyzing a relationship between factors included in battery data.

In an embodiment, the indicator calculation unit 110 may calculate a graph indicating a relationship between a charging rate and an open voltage, included in the battery data, in operation S110.

The indicator calculation unit 110 may shift the graph indicating the relationship between the charging rate and the open voltage at preset intervals, in operation S120.

The indicator calculation unit 110 may calculate an abnormality diagnosis criterion for the voltage deviation with respect to the charging rate, based on a difference between the graph before shifted and the graph after shifted, in operation S130.

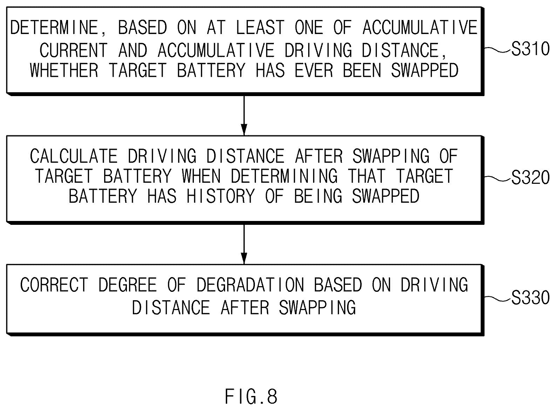

FIG. 8 is a flowchart for describing an example of a process of correcting a degree of degradation, according to an embodiment disclosed herein.

Referring to FIG. 8, the diagnosis apparatus 120 may determine whether the target battery has ever been swapped, and correct a degree of degradation. A process, performed by the diagnosis apparatus 120, of correcting a degree of degradation based on whether the target battery has ever been swapped may include operation S310 of determining, based on at least one of an accumulative current and an accumulative driving distance, whether the target battery has ever been swapped, operation S320 of calculating a driving distance after swapping of the target battery when determining that the target battery has a history of being swapped, and operation S330 of correcting a degree of degradation based on the driving distance after swapping.

In operation S310, the diagnosis apparatus 120 may determine whether the target battery has ever been swapped. In an embodiment, the diagnosis apparatus 120 may determine whether the target battery has ever been swapped, based on at least one of the accumulative current and the accumulative driving distance of the target battery.

In operation S320, the diagnosis apparatus 120 may calculate the driving distance after swapping of the target battery.

In operation S330, the diagnosis apparatus 120 may correct the degree of degradation based on the driving distance after swapping. For example, the diagnosis apparatus 120 may calculate the degree of degradation by substituting the driving distance after swapping and a use habit into the diagnosis criterion.

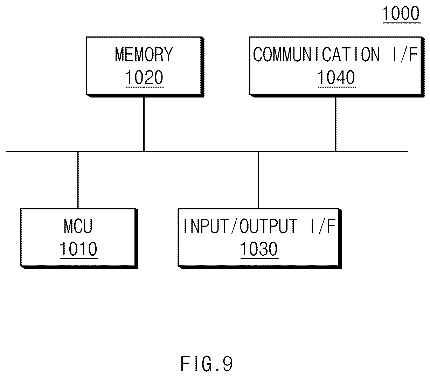

FIG. 9 is a block diagram showing a hardware configuration of a computing system for performing a battery diagnosis method, according to an embodiment disclosed herein.

Referring to FIG. 9, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs stored in the memory 1020, processes various information through these programs, and performs the above-described functions of the battery diagnosis system shown in FIG. 1.

The memory 1020 may store various programs such as a diagnosis criterion calculation program, a use feature calculation program, a diagnosis program, etc. The memory 1020 may store various information such as diagnosis data, a diagnosis result, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication.

As such, a computer program according to an embodiment disclosed herein may be recorded in the memory 1020 and processed by the MCU 1010, thus being implemented as a module that performs functions shown in FIG. 1.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

## Claims

1. A battery diagnosis system comprising:
an indicator calculation unit configured to establish a database of battery data related to a battery and calculate a diagnosis criterion for diagnosing the battery and a diagnosis indicator applied to the diagnosis criterion, based on the battery data; and
a diagnosis apparatus configured to:
obtain diagnosis data related to a target battery mounted on a vehicle;
calculate a value of the diagnosis indicator of the target battery based on the diagnosis data; and
diagnose the target battery based on the value of the diagnosis indicator and the diagnosis criterion.

2. The battery diagnosis system of claim 1, wherein the diagnosis indicator comprises a use feature of the battery and an accumulative driving distance of the vehicle, and
the diagnosis apparatus is further configured to:
calculate the use feature based on an accumulative power and an accumulative current of the target battery, included in the diagnosis data; and
diagnose a degree of degradation of the target battery by comparing the use feature and the accumulative driving distance with the diagnosis criterion.

3. The battery diagnosis system of claim 2, wherein the use feature comprises a fast charging rate of the target battery, and
the diagnosis apparatus is further configured to calculate the fast charging rate based on a ratio of the accumulative power to the accumulative current.

4. The battery diagnosis system of claim 3, wherein
the accumulative power comprises an accumulative charging power and an accumulative discharging power, and
the accumulative current comprises an accumulative charging current and an accumulative discharging current, and
the diagnosis apparatus is further configured to calculate the fast charging rate based on a ratio of the accumulative charging power to the accumulative charging current and a ratio of the accumulative discharging power to the discharging current.

5. The battery diagnosis system of claim 2, wherein the diagnosis apparatus is further configured to determine, based on at least one of the accumulative current and the accumulative driving distance, whether the target battery has ever been swapped.

6. The battery diagnosis system of claim 5, wherein the diagnosis apparatus is further configured to determine, based on a change of the accumulative current over time, whether the target battery has ever been swapped.

7. The battery diagnosis system of claim 6, wherein the diagnosis apparatus is further configured to determine that the target battery has a history of being swapped, when the accumulative current sharply decreases from a specific point in time.

8. The battery diagnosis system of claim 5, wherein the diagnosis apparatus is further configured to determine, based on a ratio of the accumulative driving distance to the accumulative current, whether the target battery has ever been swapped.

9. The battery diagnosis system of claim 8, wherein the diagnosis apparatus is further configured to determine that the target battery has a history of being swapped, when the ratio of the accumulative driving distance to the accumulative current exceeds a threshold value or a graph indicating a relationship between the accumulative driving distance and the accumulative current, when extended, does not converge to an origin.

10. The battery diagnosis system of claim 5, wherein the diagnosis apparatus is further configured to, when determining that the target battery has a history of being swapped, calculate the driving distance of the target battery after swapping and correct the degree of degradation based on the driving distance after swapping.

11. The battery diagnosis system of claim 2, wherein the indicator calculation unit is further configured to calculate the diagnosis criterion and the diagnosis indicator by analyzing a correlation between the accumulative driving distance and the degree of degradation and a correlation between a charging habit and the degree of degradation.

12. The battery diagnosis system of claim 11, wherein the indicator calculation unit is further configured to:
calculate the diagnosis indicator and the diagnosis criterion according to a type of the vehicle; and
estimate a diagnosis criterion and a diagnosis indicator of another vehicle, based on a charging habit for each vehicle and a stored/left voltage.

13. The battery diagnosis system of claim 1, wherein the indicator calculation unit is further configured to calculate a diagnosis criterion and a diagnosis indicator for diagnosing abnormality of the battery based on the battery data.

14. The battery diagnosis system of claim 13, wherein the diagnosis criterion comprises a criterion for at least any one of a voltage deviation, a temperature deviation, and an insulation resistance.

15. The battery diagnosis system of claim 13, wherein the diagnosis indicator comprises a charging rate (a state of charge (SOC)) and an open voltage (an open circuit voltage (OCV)), and
the indicator calculation unit is further configured to:
calculate a graph indicating a relationship between the charging rate (SOC) and the open voltage (OCV);
shift the graph at preset intervals; and
calculate the diagnosis criterion for a voltage deviation with respect to the charging rate, based on a difference between the graph before shifted and the graph after shifted.

16. The battery diagnosis system of claim 1, wherein the diagnosis data is obtained from on-board diagnostic (OBD) equipment included in the vehicle in a short period of time.

17. The battery diagnosis system of claim 1, wherein the diagnosis apparatus is further configured to transmit a diagnosis result for the target battery to an external device.

18. A battery diagnosis method comprising:
establishing a database of battery data related to a battery and calculating a diagnosis criterion for diagnosing the battery and a diagnosis indicator applied to the diagnosis criterion, based on the battery data;
obtaining diagnosis data related to a target battery mounted on a vehicle;
calculating a value of the diagnosis indicator of the target battery based on the diagnosis data; and
diagnosing the target battery based on the value of the diagnosis indicator and the diagnosis criterion.

19. The battery diagnosis method of claim 18, wherein the diagnosis indicator comprises a use feature of the battery and an accumulative driving distance of the vehicle, and
the calculating of the value of the diagnosis indicator comprises calculating the use feature based on an accumulative power and an accumulative current of the target battery, included in the diagnosis data, and
the diagnosing of the battery comprises diagnosing a degree of degradation of the target battery by comparing the use feature and the accumulative driving distance with the diagnosis criterion.

20. The battery diagnosis method of claim 19, wherein the diagnosing of the battery comprises:
determining, based on at least one of the accumulative current and the accumulative driving distance, whether the target battery has ever been swapped;
calculating a driving distance after swapping of the target battery when determining that the target battery has a history of being swapped; and
correcting the degree of degradation based on a driving distance after swapping.

21. The battery diagnosis method of claim 18, wherein the diagnosis indicator comprises a charging rate (a state of charge (SOC)) and an open voltage (an open circuit voltage (OCV)), and
the calculating of the diagnosis criterion and the diagnosis indicator applied to the diagnosis criterion comprises:
calculating a graph indicating a relationship between the charging rate (SOC) and the open voltage (OCV);
shifting the graph at preset intervals; and
calculating a diagnosis criterion for diagnosing abnormality of the battery for a voltage deviation with respect to the charging rate, based on a difference between the graph before shifted and the graph after shifted.
